# EUROPEAN PATENT SPECIFICATION

(11) **EP 4 465 804 B1**
(45) Date of publication and mention of the grant of the patent: **11.11.2026**
(21) Application number: 24175018.1
(22) Date of filing: 09.05.2024
(51) Int. Cl.: H10N 70/20

(54) **PHASE CHANGE MEMORY ELEMENT PARTICULARLY SUITABLE FOR EMBEDDED AND AUTOMOTIVE APPLICATIONS**
PHASENWECHSELSPEICHERELEMENT, INSBESONDERE GEEIGNET FÜR EINGEBETTETE UND KRAFTFAHRZEUGANWENDUNGEN
ELÉMENT DE MÉMOIRE À CHANGEMENT DE PHASE PARTICULIÈREMENT ADAPTÉ POUR DES APPLICATIONS EMBARQUÉES ET AUTOMOBILES

(30) Priority: 17.05.2023 IT 202300009990
(43) Date of publication of application: 20.11.2024
(73) Proprietor: STMicroelectronics International N.V., 1228 Plan-les-Ouates, Geneva (CH)
(72) Inventor: BORGHI, Massimo, 21040 GERENZANO (VA) (IT); GILARDINI, Annalisa, 20064 GORGONZOLA (MI) (IT); PALUMBO, Elisabetta, 20871 VIMERCATE (MB) (IT); PRELINI, Carlo Luigi, 20822 SEVESO (MB) (IT); ZULIANI, Paola, 20147 MILANO (IT)
(74) Representative: Studio Torta S.p.A.

(56) References cited:
- EP-A1- 4 187 540
- WO-A1-2011/119175
- US-A1- 2014 376 309
- US-A1- 2021 249 592
- US-A1- 2022 020 923

## Description

### Technical Field

The present invention relates to a phase change memory element particularly suitable for embedded and automotive applications.

### Background

As is known, non-volatile phase change memories (PCMs) use materials that may switch between two or more stable states characterized by different electrical properties. For instance, such materials are able to switch between a disorderly, amorphous, phase and an orderly, crystalline or polycrystalline phase, and the two phases are associated to resistivities having considerably different values that may be used to store data.

To this end, the chemical elements of Group VI of the Periodic Table, such as tellurium (Te), selenium (Se), germanium (Ge) or antimony (Sb), referred to as chalcogenides or chalcogenic materials, are commonly used.

Phase changes are obtained by locally increasing the temperature of the cells of chalcogenic material, through resistive electrodes (generally known as heaters) arranged in contact with respective regions of chalcogenic material.

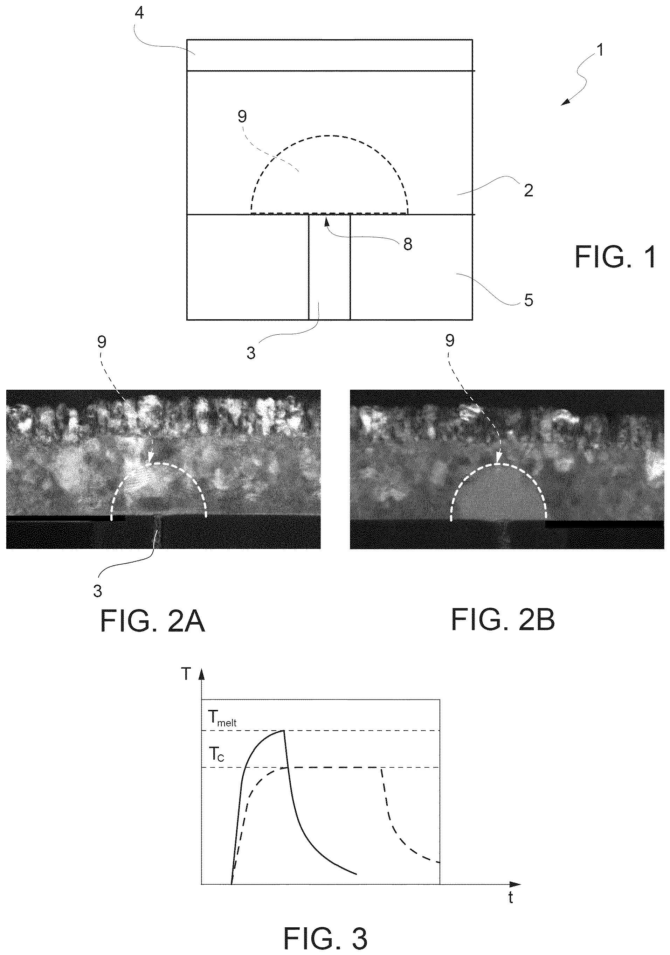

For example, Figure 1 shows cross-section of a phase change memory element 1, with a wall-shaped heater.

Phase change memory element 1 includes a memory region 2 of a chalcogenic material, in contact with a first electrode 3, here a bottom electrode, and with a second electrode 4, here an upper electrode.

Memory region 2 may be a GeₓSb_{y}Te_{z} alloy (also known as GST alloy) .

Electrodes 3, 4 are of an electrically conductive material, for example TiN or TaN. The first electrode 3 has a very small width, such as to define a smaller contact area with respect to the second electrode 4. For example, the first electrode 3 may have a width of a few nanometers and be formed in a pore or in an elongated trench in a dielectric layer 5 (the latter configuration, also called wall configuration). In particular, in case the first electrode 3 extends in an elongated trench, it extends transversely to the memory region.

A selection device (for example, a MOSFET, not shown) is connected to the first electrode/heater 3 and enables passage of an electric current that, by Joule effect, heats the chalcogenic material to obtain the desired temperature for phase change.

Due to the small width of the first electrode 3, current flowing in the first electrode 3 is concentrated and causes heating of a portion of the memory region 2 above a contact area 8 (phase change portion 9, having semi-cylindrical or hemispherical shape). Therefore, the first electrode 3 acts as a heater.

In particular, to program the phase change memory element 1 to its crystalline state (low resistance state, also called set state), an electrical pulse is applied to heat the memory region 2, and in particular the phase change portion 9, above its crystallization temperature. By allowing the memory region 2 to slowly cool down to normal operating temperature, the phase change portion 9 maintains the polycrystalline phase. See, *e.g.,* Figure 2A.

To program the phase change memory element 1 to the amorphous phase (high resistance state, also called reset state, writing), the material is heated at a higher temperature than the set state programming temperature, inducing the melting of the chalcongenide. By abruptly cutting off the electrical current pulse, the sudden cooling down of the phase change material prevents the reconfiguration thereof to the polycrystalline phase allowing solidification in a disorderly phase (amorphous phase). See, *e.g.,* Figure 2B.

Figure 3 shows possible plots of temperature T as a function of time t for programming the phase change memory element with a reset pulse (continuous line) and a set pulse (dotted line) in the ideal condition of uniform temperature in the whole memory region 2. In fact, a decreasing temperature gradient is present, from the first electrode 3 to the second electrode 4, within the phase change memory element. In any case, phase change portion 9 follows the shown behavior reported in Figure 3.

During reading, the state of the chalcogenic material is detected by applying a voltage that is sufficiently low as avoid an excessive heating, and then by reading the current flowing in the memory element 1. Since the current is proportional to the conductivity of phase change memory element 1, it is possible to determine in which state the memory element is and therefore read the stored datum.

Memories including phase change memory elements are one of the most promising type of memory due to their easy integration with advanced logics and their costs, but their reliability is still not always sufficient to meet the requirements existing in some applications.

In fact, traditionally, for forming the memory region (2, in Figure 1), among the available GST materials, the (Ge₂Sb₂Te₅) 225 alloy has been widely preferred and studied, owing to its excellent crystallization and stability properties. However, it has shown retention problems of the amorphous phase (used to identify the logic state 0) at high temperature.

Therefore, different alloys have been proposed; for example, it has been proposed to dope the 225 alloy with impurities, to obtain higher crystallization temperatures, better structural and thermal stability as well as higher switching speed.

Further research has instead been directed towards Ge-enriched alloys, **i.e.** alloys in which Ge is a predominant component of the average composition (also called Ge-rich alloys), which have shown an increase in the crystallization temperature, so as to obtain a greater capability to preserve the datum, without degrading the cycling performances (data retention and endurance).

In particular, in these alloys, the percentage of Ge in the GST alloy may be higher than 50%.

However, these solutions do not allow to fully meet the strict requirements existing in automotive applications or for memories embedded in an embedded device or circuit (such as a processor, calculation unit and the like), so-called "embedded" memories, in particular due to thermal treatments of the memory performed during the final processing steps (assembly of the die on the board and/or on packaged devices) or during operation and which may cause poor data retention.

US 2021/249592 A1 and WO 2011/1191175A1 disclose phase change memories having a storage portion comprising a GST alloy doped with other dopants, including **N.**

EP 4 187 540 (intermediate application) discloses a GST alloy with optional N doping.

US 2014/376309 A1 and US 2022/020923 disclose other phase change memories, program methods and cell structure.

The aim of the present invention is to provide a memory device overcoming the drawbacks of the prior art.

### Summary

According to the present invention a phase change memory element is provided, as defined in independent claim 1. Further advantageous features are set out in the dependent claims.

### Brief Description of the Drawings

For a better understanding of the present invention, an embodiment thereof is now described, purely by way of nonlimiting example, with reference to the attached drawings, wherein:
- Figure 1 is a cross-section of a phase change memory element;
- Figures 2A and 2B are images obtained through electron Dark Field (DF) Scanning Transmission Electron Microscope (STEM) of the phase change memory element of Figure 1, in the set state and, respectively, in the reset state;
- Figure 3 shows exemplary plots of temperatures versus time during set/reset operations of the phase change memory cell of Figure 1;
- Figure 4 is a cross-section of a phase change memory element according to the present invention;
- Figure 5 shows a ternary diagram representing the relative amounts of ions/atoms in a region comprising a GST alloy;
- Figure 6 shows the plot of the resistivity as a function of temperature for a GST alloy of the ternary diagram of Figure 5 and for a nitrogen-enriched GST alloy, as described below;
- Figures 7A-7B show current-voltage curves measured in a plurality of memory elements using respectively a GST 447 alloy and an alloy according to the present invention;
- Figures 8A-8B show resistance plots following the application of current pulses in a plurality of memory elements using, respectively, a GST 447 alloy and an alloy according to the present invention;
- Figures 9A-9B show the resistance change for the set state and for the reset state caused by heating in a plurality of memory elements using, respectively, a GST 447 alloy and an alloy according to the present invention;
- Figures 10A and 10B are images obtained through electron Dark Field (DF) Scanning Transmission Electron Microscope (STEM) of the phase change memory element of Figure 4, immediately after deposition of the various layers and, respectively, after thermal treatment steps; and
- Figures 11A and 11B are images obtained through EELS (Electron Energy Loss Spectroscopy) technique of the phase change memory element of Figure 4, immediately after deposition of the various layers and, respectively, after thermal treatment steps.

### Description of Embodiments

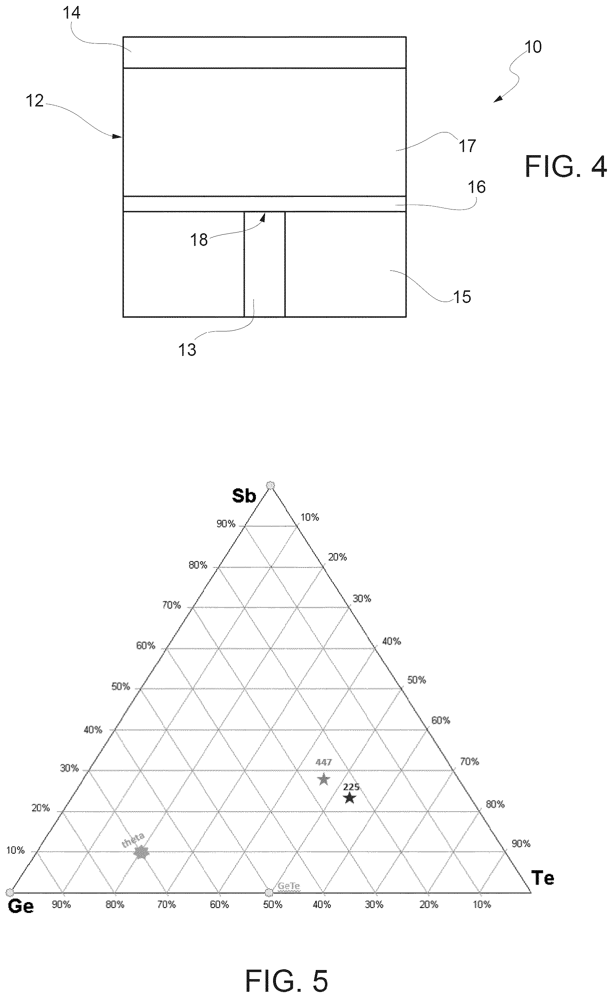

Figure 4 shows a phase change memory element (hereinafter, memory element 10) having a wall electrode, with a general configuration similar to the memory element 1 of Figure 1.

In detail, the memory element 10 of Figure 4 comprises a memory region 12 arranged between a first electrode 13 (also called heater) and a second electrode 14 (also called upper electrode).

The first and the second electrodes 13, 14 are of an electrically conductive material, for example TiN or TaN.

Similarly to Figure 1, the first electrode 13 has a very small width, such as to define a contact area 18 with the memory region 12 of small dimensions (for example a few nanometers); in particular, the contact area between the first electrode 13 and the memory region 12 is much smaller than the contact area between the memory region 12 and the second electrode 14.

The first electrode 13 is formed in a dielectric layer 15. For example, the first electrode 13 may be formed in a pore or an elongated trench formed in the dielectric layer 15; in this second case (wall configuration), it extends transversely to the memory region 12.

For example, the dielectric layer 15 may comprise silicon oxide and/or silicon nitride.

The memory region 12 comprises a phase change material and more precisely a GST alloy, wherein the average percentage of germanium is higher than 50%, as described in detail below.

In particular, the memory region 12 is here formed by an interface layer 16 and by a storage portion 17, both of phase change material but with different stoichiometries. Preferably, in the storage portion 17, the percentage of germanium is higher than 50%, as described in detail below.

The interface layer 16 extends above the first electrode 13 and the dielectric layer 15, in direct electrical contact with the first electrode 13.

The storage portion 17 extends above the interface layer 16, between the latter and the second electrode 14.

The interface layer 16 may have a thickness comprised between 0 and 10 nanometers. For example, the interface layer 16 has a thickness equal to about one tenth of the memory region 12.

For example, for a memory region 12 having a thickness of about 50 nanometers, the interface layer 16 may have a thickness of 5 nanometers and the storage region 17 a thickness of 45 nm.

As indicated above, the memory region 12 comprises a GST alloy.

Specifically, the storage portion 17 comprises a GST (germanium-antimony-tellurium) alloy having a percentage of germanium higher than or equal to 50% and a percentage of electrically relevant nitrogen.

In particular, the GST alloy forming the storage portion 17 may be based on the GST 712 (Ge₇Sb₁Te₂) alloy, also called theta alloy.

Furthermore, the expression "percentage of electrically relevant nitrogen" means a compositional percentage of nitrogen comprised between 5% and 25% (boundaries included).

In particular, according to the present invention, the storage portion 17 is formed by a quaternary alloy based on germanium Ge, antimony Sb, tellurium Te and nitrogen N (GeₓSb_{y}Te_{z}N_{J}), wherein the percentage of nitrogen is comprised between 5% and 25 %, preferably between 8% and 21%, more preferably between 11% and 18%, even more preferably between 13% and 15%; for example, the percentage of nitrogen is equal to 14%.

In addition, according to the present invention, the alloy of the storage portion 17 includes a percentage of germanium comprised between 60% and 68%; a percentage of antimony comprised between 9% and 5%; and a percentage of tellurium comprised between 18% and 10%.

The Applicant has observed that the addition of amounts of nitrogen in percentages within the above ranges allows the crystallization temperature of the alloy to be increased. In this way, it is possible to increase the retention capability of the memory region 12 (and, in particular, of the storage portion 17) following thermal treatments, for example after soldering the chip embedding the memory on a board meeting the JEDEC standard J-STD-020C. This also allows the use of the memory element in the automotive field as to the temperature retention characteristics (compliance after thermal treatment - High Temperature Data Retention, HTDR).

In particular, according to the present invention, the storage portion 17 contains an alloy comprised between the alloy having stoichiometry Ge₆₈Sb₀₉Te₁₈N₀₅ and the alloy having stoichiometry Ge₆₀Sb₀₅Te₁₀N₂₅.

In particular, the percentage of nitrogen is comprised between 8% and 21% (boundaries included), more preferably between 11% and 18% (boundaries included), even more preferably between 13% and 15% (boundaries included); for example, the percentage of nitrogen is equal to 14%.

The percentage of germanium is comprised between 60% and 68%, preferably between 61% and 67%, more preferably between 62% and 66%, even more preferably between 63% and 65%, for example it is equal to 64%.

Furthermore, the percentage of antimony is comprised between 9% and 5% , preferably between 8% and 6% , for example it is equal to 7%.

The percentage of tellurium is comprised between 18% and 10%, preferably between 17% and 12%, more preferably between 16% and 14%, for example it is equal to 15%.

Furthermore, the alloy of the storage portion 17 indicated above may include other residual ions/atoms and/or impurity elements which do not alter the basic operating principles and physical characteristics of the GSTN alloy in terms of chemical and morphological distribution of ions.

In the present disclosure, "impurity element" means any element not belonging to the group: germanium, antimony, tellurium and nitrogen, for example carbon, oxygen, argon, hydrogen.

These impurity elements are generally present to an undetectable extent and in any case to an extent lower than or equal to 2.0%.

Obviously, as clear to the person skilled in the art, in the alloy of the storage portion 17, the sum of the percentages of germanium, antimony, tellurium and nitrogen (and possible impurity elements) is 100%.

In particular, the alloy used for the storage region 17 has stoichiometry Ge₆₄Sb₀₇Te₁₅N₁₄.

The interface layer 16 comprises a GST alloy leaner in germanium and richer in tellurium and antimony than the storage portion 17; for example, the interface layer 16 has a percentage of tellurium higher than 45% and/or a percentage of germanium lower than 40%.

For example, according to the present disclosure, for the interface layer 16, GST alloys are considered having stoichiometry Ge₂₂Sb₂₂Te₅₆ (GST225 alloy) or Ge₂₇Sb₂₇Te₄₆ (GST447 alloy) and intermediate alloys, with a variation of ±1% of the different elements.

Therefore, alloys having a percentage of germanium comprised between 21% and 28%, a percentage of antimony comprised between 21% and 27%, and a percentage of tellurium comprised between 45% and 55% are also usable.

Furthermore, the alloy of the interface layer 16 indicated above may include other residual ions/atoms and/or impurity elements which do not alter the basic operating principles and physical characteristics of the alloy in terms of chemical and morphological distribution of ions.

Obviously, as clear to the person skilled in the art, for the interface layer 16, the sum of the percentages of germanium, antimony and tellurium (and possible impurity elements) is 100%.

Figure 5 shows a ternary diagram of the sole elements Ge, Sb and Te, having the regions relating to the usable alloys, defined above, for forming the storage portion 17 highlighted, without considering the nitrogen concentration.

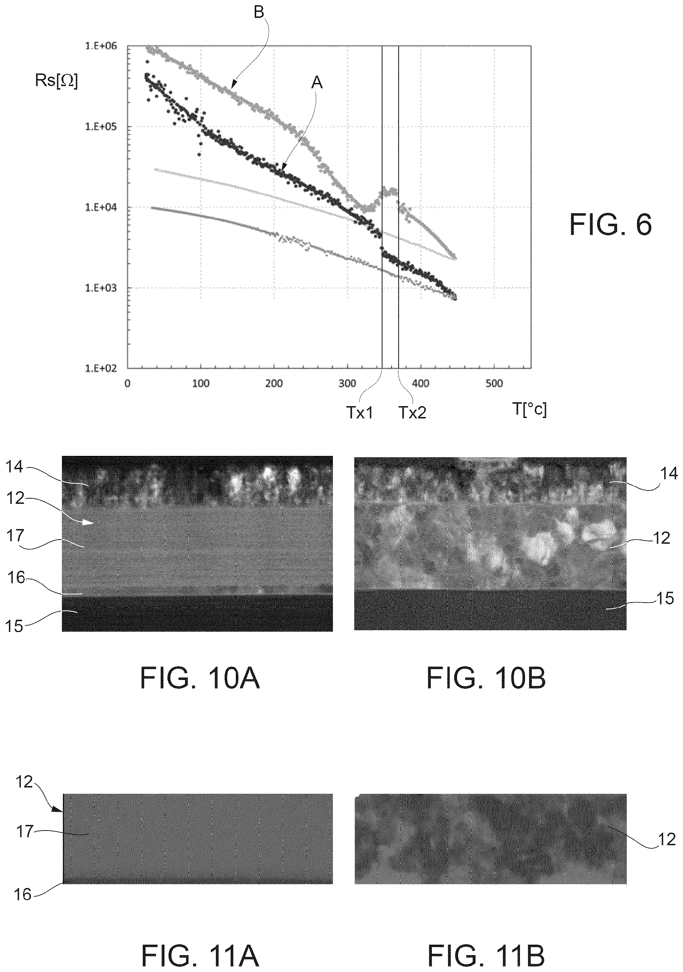

For the alloys indicated by a star and for the alloy having stoichiometry Ge₆₄Sb₀₇Te₁₅N₁₄, comparative tests have been carried out as to crystallization temperature, functionality and retention capability, described hereinbelow with reference to Figures 6-10B.

Figure 6 shows the dependence of the resistivity ρ (measured in Ω·cm), of non-defined layers - on an unpatterned wafer - formed using the theta alloy (GST 712 alloy, without addiction of nitrogen, curve A) and the GST 712 alloy with addition of nitrogen (curve B).

In particular, these curves have been obtained starting from amorphous-state material, gradually increasing the temperature up to about 450°C, for example using a slow ramp, with a speed of 10°C/min, so as to induce the crystallization of the material and then reducing the temperature down to room temperature, for example using a ramp rate similar to the previous one, to measure the resistivity of the crystalline state.

As noted, both alloys have a generally similar behavior, with a reduction in resistivity as the temperature increases (upper branch of curves A, B); one step downwards at a temperature called crystallization temperature (Tx1, for curve A, theta alloy without further doping, and Tx2, for curve B, N-doped theta alloy), which causes the phase transition) and the more or less constant maintenance of the resistivity value while reducing the temperature (lower branch of curves A, B).

As noted, the GeₓSb_{y}Te_{z}N_{J} alloy has a higher crystallization temperature than the theta alloy.

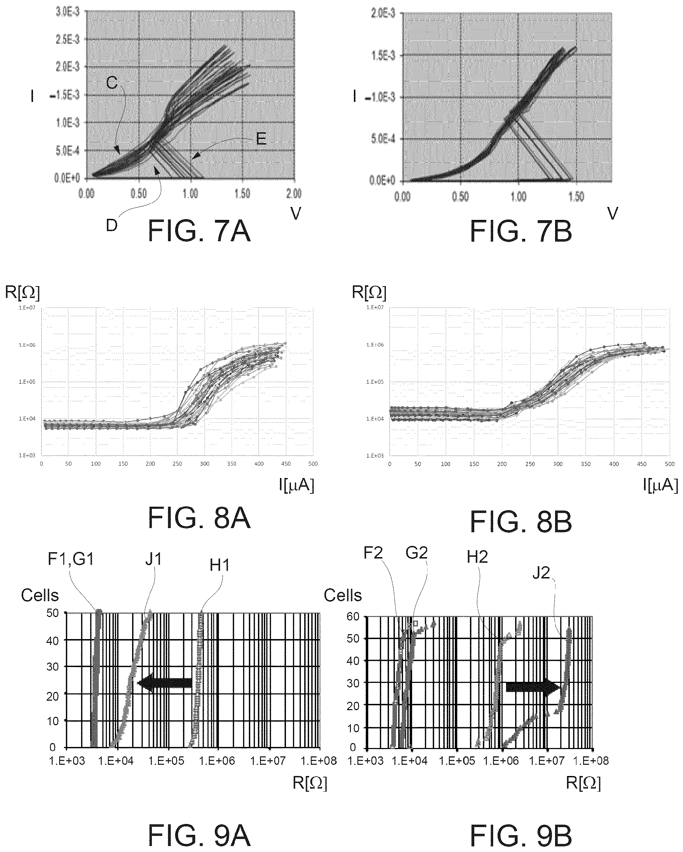

The GeₓSb_{y}Te_{z}N_{J} alloy also has an electrical behavior comparable to that of other alloys, as shown in the comparative examples of Figures 7A, 7B, 8A, 8B, 9A and 9B.

In detail, Figure 7A shows the current-voltage curves I-V of a plurality of phase change memory elements (hereinafter also referred to as memory cells) using a GST 447 alloy. In these curves, the curve portions increasing in an approximately linear manner at 45° (with a positive slope representative of a series resistance of the first electrode - heater 13 - sections C) relate to memory cells programmed to the crystalline state (set memory cells, logic "1"), having substantially resistive behavior; the curve portions (barely visible, sections D) having zero current (up to about 1V) relate to memory cells programmed to the amorphous state (reset memory cells, logic "0"), and therefore nonconductive. For these latter curve portions, after the value of about 1V, an electronic switching phenomenon occurs and the curves abruptly modify their trend and, after a transition phase detectable from the negative-slope portions (sections E), follow the trend at, approximately, +45°C of the curves of the memory cells programmed to the crystalline state.

Figure 7B shows the current-voltage curves I-V of a plurality of memory cells using the above-described GeₓSb_{y}Te_{z}N_{J} alloy. As noted, the curves of Figure 7B also show the same type of trend described above, but the memory cells in the amorphous state change state at higher voltage, demonstrating, on the one hand, the correct electrical behavior and, on the other, the increase of the threshold voltage for the amorphous phase obtained with the GeₓSb_{y}Te_{z}N_{J} alloy, ensuring a further margin on the usable reading voltage.

Figure 8A shows the plot of the resistance of memory cells using a GST 447 alloy after the application of current pulses I having increasing value (on the abscissa), in case of cells programmed to the set state.

As noted, initially the memory cells maintain approximately constant resistance, with a very low value; as the current pulses increase, the curves begin to modify their trend, following the melting of the memory region subject to phase change (similarly to the phase change portion 9 having a semi-cylindrical or hemispherical shape of Figure 1), reaching the amorphous state, having higher resistance.

Figure 8B shows the similar plot of the resistance of memory cells using the above-described GeₓSb_{y}Te_{z}N_{J} alloy. As noted, the curves of Figure 8B also show the same type of trend described above, ensuring correct electrical behavior.

Figure 9A shows the resistance shift in a plurality of memory cells using a GST 447 alloy before and after heating for 1h at 180°C. In detail, the curve on the left (curve F1,G1) represents the resistance measured on a plurality of memory cells programmed to the set state before and after annealing (the points are substantially superimposed and therefore the two plots are substantially indistinguishable); curve H1 shows the resistance measured on a plurality of memory cells programmed to the reset state, before thermal treatment, and curve J1 shows the measurements on the same memory cells programmed to the reset state, after heating. As noted, the points of curve J1 are shifted to the left, approaching curves F1, G1 and thus creating reading errors (JEDEC non-compliance).

Figure 9B shows the similar plot of the resistance of phase change memory cells using the above-described GeₓSb_{y}Te_{z}N_{J} alloy. In this Figure, the curves identified by F2, G2, H2, J2 refer to measurements taken in memory cells programmed to the set state and in memory cells programmed to the reset state, similarly to the measurements F1-J1 indicated by the same letter.

As noted, not only curves F2, G2 of Figure 9B have a greater differentiation, with respect to curves F1, G1 of Figure 9A, as to the memory cells programmed to the reset state, curve J2, after heating, is shifted in the opposite direction with respect to the corresponding curve J1 of Figure 9B and precisely in direction of a greater resistance difference from the memory cells programmed to the set state.

Consequently, memory cells formed with the above-described GeₓSb_{y}Te_{z}N_{J} alloy, not only do not have retention problems after heating, but even better discernibility as to the average (typical) behavior of the memory cells.

Studies by the Applicant have also shown that the interface layer 16 improves the adhesion between the phase change chalcogenic material of the memory region 12 and the dielectric layer 15.

Furthermore, since, after depositing the storage portion 17 and the subsequent processing steps, the chemical elements of the interface layer 16 and of the storage portion 17 mix, the memory element 10 undergoes a slight deterioration in its retention capabilities, due to the average reduction of germanium in the memory region 12, but has an improvement in cycling (and therefore in the possibility of allowing modification of the written datum).

In particular, the thickness of the interface layer 16 may vary according to the needs, even if the values indicated above, and in particular the value of 5 nm, provide an optimal trade-off in most cases, with improvement of the adhesion and negligible degradation of the retention.

Studies carried out by the Applicant have shown that, in use, the portion of the memory region 12 above the contact area 18 forms a phase change portion with a semi-cylindrical or hemispherical shape, similarly to what discussed with reference to Figure 1 for the phase change portion 9.

Furthermore, the studies have shown that, during manufacturing and following thermal treatments which occur in the final manufacturing steps and/or during operation, the interface layer 16 is no longer distinguishable from the storage portion 17, as shown by way of example in Figures 10A, 10B, 11A and 11B, which, indeed, show the aggregation and gettering effect exerted by the interface layer 16 on the germanium atoms/ions, with formation of clusters of germanium in the zone where the interface layer 16 had been initially deposited.

As a result, the memory elements 10 formed with the GeₓSb_{y}Te_{z}N_{J} alloy and provided with an interface layer 16 show a high crystallization temperature capable of ensuring compliance with the soldering reflow profile required by the JEDEC standard, with HTDR data retention meeting the stringent automotive and embedded memory requirements, such as for IoT (Internet on Things) applications, SmartCards and the like.

Finally, it is clear that modifications and variations may be made to the phase change memory element described and illustrated herein without thereby departing from the scope of the present invention, as defined in the attached claims.

## Claims

1. A phase change memory element (10) comprising a memory region (12), a first electrode (13) and a second electrode (14),
wherein:
the memory region (12) is arranged between the first and second electrodes (13, 14);
the memory region (12) comprises a germanium-antimony-tellurium, GST, alloy with an average percentage of germanium higher than or equal to 50%, and
the memory region (12) comprises a storage portion (17), **characterized in that** the storage portion (17) is formed by an alloy including:
a percentage of germanium comprised between 60% and 68%;
a percentage of antimony comprised between 9% and 5%;
a percentage of tellurium comprised between 18% and 10%; and
a percentage of nitrogen comprised between 5% and 25%,
wherein the sum of the percentages of germanium, antimony, tellurium and nitrogen is 100%, apart from possible impurity elements.

2. The phase change memory element according to claim 1, wherein the percentage of nitrogen is comprised between 8% and 21%, preferably between 11% and 18%, more preferably between 13% and 15%.

3. The phase change memory element according to any of the preceding claims, wherein the percentage of nitrogen is equal to 14%.

4. The phase change memory element according to any of the preceding claims, wherein the percentage of germanium is comprised between 61% and 67%, preferably between 62% and 66%, more preferably between 63% and 65%.

5. The phase change memory element according to any of the preceding claims, wherein the percentage of germanium is equal to 64%.

6. The phase change memory element according to any of the preceding claims, wherein the percentage of antimony is comprised between 8% and 6%.

7. The phase change memory element according to any of the preceding claims, wherein the percentage of antimony is equal to 7%.

8. The phase change memory element according to any of the preceding claims, wherein the percentage of tellurium is comprised between 17% and 12%, preferably between 16% and 14%.

9. The phase change memory element according to any of the preceding claims, wherein the percentage of tellurium is equal to 15%.

10. The phase change memory element according to any of the preceding claims, wherein the memory region (12) further comprises an interface layer (16) formed by a GST alloy having lower germanium content with respect to the storage portion (17).

11. The phase change memory element according to the preceding claim, wherein the interface layer (16) contains a percentage of tellurium higher than 45% and a percentage of germanium lower than 40%.

12. The phase change memory element according to claim 10 or 11, wherein the interface layer (16) comprises a percentage of germanium comprised between 21% and 28%, a percentage of antimony comprised between 21% and 27% and a percentage of tellurium comprised between 45% and 55%.

13. The phase change memory element according to any of the preceding claims, wherein the first electrode (13) has a wall or pore shape and has a first contact area (18) with the memory region (12) and the second electrode (14) has a second contact area with the memory region (12), the first contact area (18) having a smaller dimension than the second contact area.

14. The phase change memory element according to the preceding claim, wherein the memory region (12) comprises an interface layer (16), the interface layer (16) is in direct contact with the first electrode (13) and the storage portion (17) is in direct contact with the second electrode (14).

## Patentansprüche

1. Phasenwechselspeicherelement (10), umfassend einen Speicherbereich (12), eine erste Elektrode (13) und eine zweite Elektrode (14),
wobei:
der Speicherbereich (12) zwischen der ersten und zweiten Elektrode (13, 14) angeordnet ist;
der Speicherbereich (12) eine Germanium-Antimon-Tellur-, GST-Legierung, mit einem durchschnittlichen Prozentsatz an Germanium von mehr als oder gleich 50 % umfasst, und
der Speicherbereich (12) einen Speicherabschnitt (17) umfasst, **dadurch gekennzeichnet, dass** der Speicherabschnitt (17) durch eine Legierung gebildet ist,
die Folgendes enthält:
einen Prozentsatz an Germanium, der zwischen 60 % und 68 % umfasst ist;
ein Prozentsatz an Antimon, der zwischen 9 % und 5 % umfasst ist;
ein Prozentsatz an Tellur, der zwischen 18 % und 10 % umfasst ist; und
einen Prozentsatz an Stickstoff, der zwischen 5 % und 25 % umfasst ist,
wobei die Summe der Prozentsätze an Germanium, Antimon, Tellur und Stickstoff abgesehen von möglichen Verunreinigungselementen 100 % beträgt.

2. Phasenwechselspeicherelement nach Anspruch 1, wobei der Prozentsatz an Stickstoff zwischen 8 % und 21 %, vorzugsweise zwischen 11% und 18 %, bevorzugter zwischen 13 % und 15 % umfasst ist.

3. Phasenwechselspeicherelement nach einem der vorstehenden Ansprüche, wobei der Prozentsatz an Stickstoff gleich 14 % ist.

4. Phasenwechselspeicherelement nach einem der vorstehenden Ansprüche, wobei der Prozentsatz an Germanium zwischen 61 % und 67 %, vorzugsweise zwischen 62 % und 66 %, bevorzugter zwischen 63 % und 65% umfasst ist.

5. Phasenwechselspeicherelement nach einem der vorstehenden Ansprüche, wobei der Prozentsatz an Germanium gleich 64 % ist.

6. Phasenwechselspeicherelement nach einem der vorstehenden Ansprüche, wobei der Prozentsatz an Antimon zwischen 8 % und 6 % umfasst ist.

7. Phasenwechselspeicherelement nach einem der vorstehenden Ansprüche, wobei der Prozentsatz an Antimon gleich 7 % ist.

8. Phasenwechselspeicherelement nach einem der vorstehenden Ansprüche, wobei der Prozentsatz an Tellur zwischen 17 % und 12 %, vorzugsweise zwischen 16 % und 14 %, umfasst ist.

9. Phasenwechselspeicherelement nach einem der vorstehenden Ansprüche, wobei der Prozentsatz an Tellur gleich 15 % ist.

10. Phasenwechselspeicherelement nach einem der vorstehenden Ansprüche, wobei der Speicherbereich (12) weiter eine Schnittstellenschicht (16) umfasst, die durch eine GST-Legierung gebildet wird, die einen geringeren Germaniumgehalt in Bezug auf den Speicherabschnitt (17) aufweist.

11. Phasenwechselspeicherelement nach dem vorstehenden Anspruch, wobei die Schnittstellenschicht (16) einen Prozentsatz an Tellur von mehr als 45 % und einen Prozentsatz an Germanium von weniger als 40 % beinhaltet.

12. Phasenwechselspeicherelement nach Anspruch 10 oder 11, wobei die Schnittstellenschicht (16) einen Prozentsatz an Germanium umfasst, der zwischen 21 % und 28 % umfasst ist, einen Prozentsatz an Antimon, der zwischen 21 % und 27 % umfasst ist, und einen Prozentsatz an Tellur, der zwischen 45 % und 55 % umfasst ist.

13. Phasenwechselspeicherelement nach einem der vorstehenden Ansprüche, wobei die erste Elektrode (13) eine Wand- oder Porenform aufweist und eine erste Kontaktfläche (18) mit dem Speicherbereich (12) aufweist und die zweite Elektrode (14) eine zweite Kontaktfläche mit dem Speicherbereich (12) aufweist, wobei die erste Kontaktfläche (18) eine kleinere Abmessung als die zweite Kontaktfläche aufweist.

14. Phasenwechselspeicherelement nach dem vorstehenden Anspruch, wobei der Speicherbereich (12) eine Schnittstellenschicht (16) umfasst, die Schnittstellenschicht (16) in direktem Kontakt mit der ersten Elektrode (13) steht, und der Speicherabschnitt (17) in direktem Kontakt mit der zweiten Elektrode (14) steht.

## Revendications

1. Elément de mémoire à changement de phase (10) comprenant une région de mémoire (12), une première électrode (13) et une seconde électrode (14),
dans lequel :
la région de mémoire (12) est agencée entre les première et seconde électrodes (13, 14) ;
la région de mémoire (12) comprend un alliage de germanium- antimoine-tellure, GST avec un pourcentage moyen de germanium supérieur ou égal à 50%, et
la région de mémoire (12) comprend une partie de stockage (17), **caractérisé en ce que** la partie de stockage (17) est formée par un alliage incluant :
un pourcentage de germanium compris entre 60% et 68% ;
un pourcentage d'antimoine compris entre 9% et 5% ;
un pourcentage de tellure compris entre 18% et 10% ; et
un pourcentage d'azote compris entre 5% et 25%,
dans lequel la somme des pourcentages de germanium, d'antimoine, de tellure et d'azote est de 100%, en dehors d'éléments d'impuretés possible.

2. Elément de mémoire à changement de phase selon la revendication 1, dans lequel le pourcentage d'azote est compris entre 8% et 21%, de préférence entre 11% et 18%, plus préférablement entre 13% et 15%.

3. Elément de mémoire à changement de phase selon l'une quelconque des revendications précédentes, dans lequel le pourcentage d'azote est égal à 14%.

4. Elément de mémoire à changement de phase selon l'une quelconque des revendications précédentes, dans lequel le pourcentage de germanium est compris entre 61% et 67%, de préférence entre 62% et 66%, plus préférablement entre 63% et 65%.

5. Elément de mémoire à changement de phase selon l'une quelconque des revendications précédentes, dans lequel le pourcentage de germanium est égal à 64%.

6. Elément de mémoire à changement de phase selon l'une quelconque des revendications précédentes, dans lequel le pourcentage d'antimoine est compris entre 8% et 6%.

7. Elément de mémoire à changement de phase selon l'une quelconque des revendications précédentes, dans lequel le pourcentage d'antimoine est égal à 7%.

8. Elément de mémoire à changement de phase selon l'une quelconque des revendications précédentes, dans lequel le pourcentage de tellure est compris entre 17% et 12%, de préférence entre 16% et 14%.

9. Elément de mémoire à changement de phase selon l'une quelconque des revendications précédentes, dans lequel le pourcentage de tellure est égal à 15%.

10. Elément de mémoire à changement de phase selon l'une quelconque des revendications précédentes, dans lequel la région de mémoire (12) comprend en outre une couche interface (16) formée par un alliage de GST ayant un plus petit contenu en germanium que la partie de stockage (17).

11. Elément de mémoire à changement de phase selon la revendication précédente, dans lequel la couche interface (16) contient un par conséquent de tellure supérieur à 45% et un pourcentage de germanium inférieur à 40%.

12. Elément de mémoire à changement de phase selon la revendication 10 ou 11, dans lequel la couche interface (16) comprend un pourcentage de germanium compris entre 21% et 28%, un pourcentage d'antimoine compris entre 21% et 27% et un pourcentage de tellure comprise entre 45% et 55%.

13. Elément de mémoire à changement de phase selon l'une quelconque des revendications précédentes, dans lequel la première électrode (13) a une forme de paroi ou de pore et comporte une première surface de contact (18) avec la région de mémoire (12) et la seconde électrode (14) a une seconde surface de contact avec la région de mémoire (12), la première surface de contact (18) ayant une plus petite dimension que la seconde surface de contact.

14. Elément de mémoire à changement de phase selon la revendication précédente, dans lequel la région de mémoire (12) comprend une couche interface (16), la couche interface (16) est en contact direct avec la première électrode (13) et la partie de stockage (17) est en contact direct avec la seconde électrode (14).
